Europäisches Patentamt

European Patent Office

Office européen des brevets

(19)

(11) Publication number: **0 373 221**
**A1**

## (12) EUROPEAN PATENT APPLICATION
### published in accordance with Art. 158(3) EPC

(21) Application number: 88909820.8

(22) Date of filing: 14.11.88

(86) International application number:
PCT/JP88/01147

(87) International publication number:
WO 89/08328 (08.09.89 89/21)

(51) Int. Cl.5: **H01L 31/04**

(30) Priority: 05.03.88 JP 52075/88

(43) Date of publication of application:
20.06.90 Bulletin 90/25

(84) Designated Contracting States:
**DE FR GB IT NL**

(71) Applicant: **KANEGAFUCHI KAGAKU KOGYO KABUSHIKI KAISHA**
**2-4 Nakanoshima 3-chome**
**Kita-ku Osaka-shi Osaka 530(JP)**

(72) Inventor: **KOBAYASHI, Kenji**
**Sanseiso, 31-17 Shioya-cho 6-chome**
**Tarumi-ku Kobe-shi Hyogo 655(JP)**
Inventor: **TSUGE, Kazunori**
**9-30-1220, Maikodai 2-chome Tarumi-ku**
**Kobe-shi Hyogo 655(JP)**
Inventor: **TAWADA, Yoshihisa**
**14-39, Oikemiyamadai Kita-ku**
**Kobe-shi Hyogo 651-11(JP)**

(74) Representative: **Türk, Gille, Hrabal**
**Brucknerstrasse 20**
**D-4000 Düsseldorf 13(DE)**

(54) **FABRICATION METHOD FOR SEMICONDUCTOR DEVICE AND FILM FORMATION APPARATUS FOR SAID METHOD.**

(57) A fabrication method for the semiconductor device of the present invention is characterized by including the step in which patterning of an amorphous silicon type semiconductor layer and/or a back electrode brings a wire mask into substantially close contact with a film formation surface to form an amorphous silicon type semiconductor layer and/or the back electrode and the step in which the thin film extending to a wire portion is removed, whenever necessary. A film formation apparatus of the present invention comprises a main body for housing the substrate, a means for fixing the substrate to the main body and locating the substrate and a plurality of thin wires disposed on the film formation surface side of the substrate and to be brought into substantially close contact with the film formation surface of the substrate. In accordance with the fabrication method for the semiconductor device and the film formation apparatus for said method of the present invention, complete patterning can be made even when an extremely thin film is formed around the wire portion and the production yield can be improved. It is not necessary to make strict adjustment of the wires and complicated steps in ordinary etching processes such as application of a resist, curing of the resist, removal of the resist,

and the like, become unnecessary.

## FIG.1

## DESCRIPTION

### FABRICATION METHOD FOR SEMICONDUCTOR DEVICE
### AND FILM FORMATION APPARATUS FOR SAID METHOD

#### TECHNICAL FIELD

The present invention relates to a fabrication method for semiconductor device and a film formation apparatus for said method. More particularly, a fabrication method for semiconductor device and a film formation apparatus for said method which can form a perfect pattern on a semiconductor layer or a back electrode of amorphous semiconductor solar cell by simple process.

Hitherto, a pattern is formed on an amorphous semiconductor layer or a back electrode for integration by energy beam such as laser.

When the pattern of amorphous semiconductor layer is formed by laser, there is a problem that the efficiency of solar cell is decreased by damage in transparent electrode or contact resistance between the transparent electrode and the back electrode changes (contact resistance increases) with the lapse of time at the part where laser scribing is performed. Further, there is a drawback that stable production cannot be done since it is difficult to form a pattern on back electrode by laser. As a result, another method such as etching method or lift-off method is reluctantly adopted. In this case, it generates different problems such as increase of manufacturing cost caused by increase of manufacturing steps and decrease of productivity. In addition, the pattern is formed after the semiconductor layer or the back electrode is formed in either method, so that manufacturing steps are increased and manufacturing cost increases accordingly.

It is an object of the present invention to provide a fabrication method for semiconductor device and a film formation apparatus for said method wherein a film forming step and a patterning step can be carried out simultaneously without decreasing the efficiency of the solar cell.

## DISCLOSURE OF THE INVENTION

The fabrication method for semiconductor device of the present invention is a method wherein a patterned transparent electrode, an amorphous silicon semiconductor layer and a back electrode are formed in this order on a substrate characterized in that patterning for the amorphous semiconductor layer and/or the back electrode is carried out by a step wherein the amorphous semiconductor layer and/or the back electrode are/is formed with wires being substantially and closely contacted with a surface whereon a film is formed, and by a step wherein undesirable film which is formed behind the wires during the above-mentioned step is removed whenever necessary.

The film formation apparatus of the present invention is an apparatus which is used to form a semiconductor layer or a back electrode of amorphous silicon solar comprising a main body which contains a substrate, a means for fixing and positioning the substrate, a plurality of fine wires which are substantially and closely contacted with the substrate by the film forming surface thereof.

## BRIEF DESCRIPTION OF THE DRAWINGS

Fig. 1 is a plan view of an embodiment of film formation apparatus of the present invention without a substrate; and

Fig. 2 is an enlarged sectional view of a film formation apparatus with a substrate taken along line A-A of Fig. 1.

## BEST MODE FOR CARRYING OUT THE INVENTION

Referring now to the drawings, there is shown a fabrication method for semiconductor device and a film formation apparatus for said method.

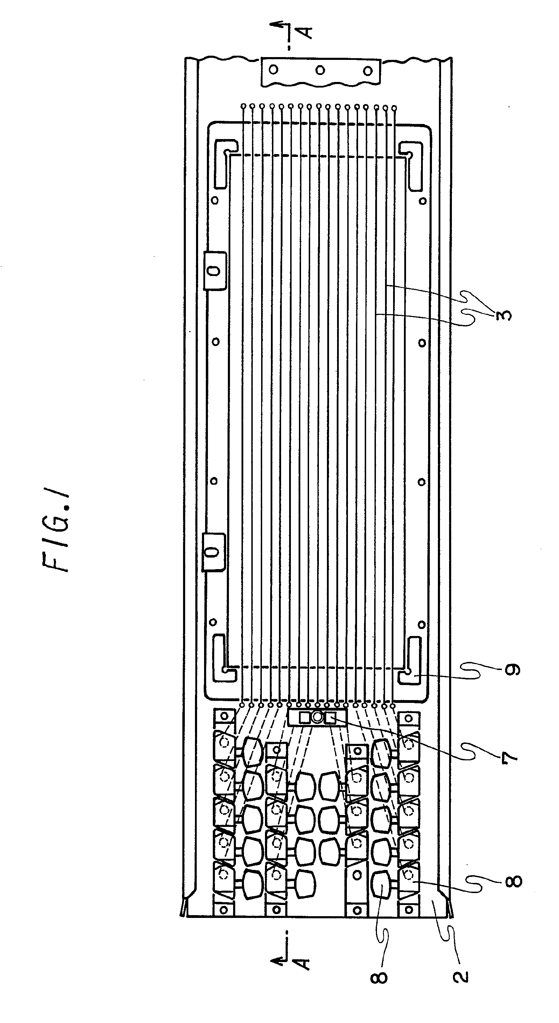

Fig. 1 is a plan view of an embodiment of film formation apparatus of the present inveniton without a substrate; and

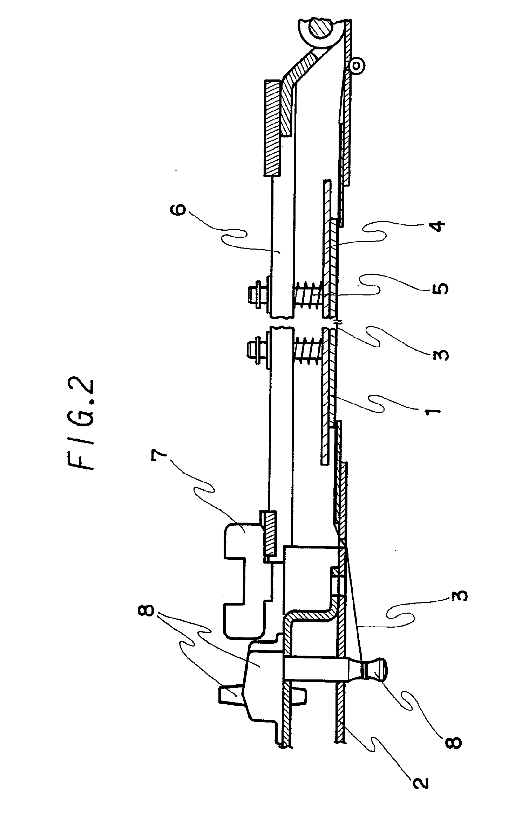

Fig. 2 is an enlarged sectional view of a film formation apparatus with a substrate taken along line A-A of Fig. 1.

Hereinafter is a description of an embodiment of the film formation apparatus applied to a plasma CVD apparatus. The application of the present invention, however, is not limited to the plasma CVD apparatus. It can be broadly applied to other film formation apparatuses such as sputtering apparatus and vapor deposition apparatus.

In Figs. 1 to 2, numeral 1 indicates a substrate comprising, for instance, a plate glass whereon a semiconductor layer and a back electrode are formed. On the substrate, a transparent electrode comprising $SnO_2$ and the like is formed by CVD method and the like, and then the transparent electrode is patterned by laser scribing method, etching method or the like.

Numeral 2 indicates a CVD tray itself, and a plurality of fine wires 3 are stretched at the upper part of substrate containing section thereof. One end of fine wires 3 are fixed to the tray 2, and the others are fixed to tension adjusting screws 8.

Fig. 2 shows the CVD tray 2 with substrate 1 of which film forming surface faces the wires 3. The substrate 1 is fixed and positioned in the tray 2 by a fixing means comprising a substrate supporting plate 4, springs 5, a back plate 6 and a retaining jig 7 for the back plate so that the surface of the substrate 1 is forcibly contacted with the wires 3. This is carried out by using elastic force of springs 5, so that close contact between the film forming surface of the substrate 1 and the wires 3 is maintained. By making the wires 3 substantially and closely contacted with the surface, a pattern wherein a transparent electrode is exposed is obtained even if the plasma CVD apparatus wherein undesirable film is apt to be formed behind the wires 3.

In a film formation apparatus of the present embodiment, since one end of the wires 3 are fixed to the tension adjusting screws 8 so that tension of the wires 3 may be adjusted, the contact degree between the film forming surface of the substrate 1 and wires 3 is enhanced by adjusting tension of the wires 3 before the substrate 1 is set to the tray 2 or after the substrate 1 is set thereto.

The width of patterning line of pattern can be suitably adjusted by selecting the wire diameter in the range of 0.08 to 2.0 mm wherein the wires 3 act a sort of mask. There is no limitation to the material of wire 3 so long as it can be safely used in the film formation methods such as plasma CVD method and sputtering method. For example, piano wire of grade A or of grade B, or nickel-titanium alloy wire can be adopted.

When undesirable slack of wires 3 occures by heat generated during film formation step, weight can be applied to a bundle of all wires, bundles of some wires or every wire in order to keep tension of wires 3 constant. Further, tension of wires 3 can be maintained in certain degree by mounting springs in the adjusting screws 8.

The above description is made by referring the plasma CVD apparatus, however, as is mentioned above, the present invention can be carried out in the same way for sputtering apparatus which is a kind of glow discharge one like the plasma CVD one. In a vapor deposition apparatus a similar method can be fully adopted since undesirable thin films are scarcely formed behind the wires.

If any undesirable thin film is found in the obtained semiconductor layer, it is removed by the undermentioned ways.

As for the amorphous semiconductor layer, Si alloy comprising other elements such as C, N, Sn, and microcrystalline thereof as well as Si element can be adopted.

As to resmoving methods for undesirable thin film formed in the patterning line, a wet etching method; dry etching methods such as plasma etching method; and a reverse sputtering method can be adopted.

When the wet etching method is adoped, it is preferable that KOH or NaOH solution is used as etchant. The undesirable thin film formed behind the wires is removed by soaking the whole substrate into the solution. And then, the whole substrate is washed by demineralized water, and is dried. Concentration of KOH or NaOH solution used is preferably in the range of 1 to 20 % by weight, more preferably in the range of 5 to 10 % by weight from the view point of not only preventing excess removal of amorphous silicon film except for undesirable thin film, but also easy control of etching. Temperature of KOH or NaOH solution is preferably in the range of 10 to 40°C, more preferably in the range of 20 to 30°C from the view point of not only preventing excess removal of amorphous silicon film except for undesirable thin film, but also easy control of etching. Etching period is preferably in the range of 10 seconds to 5 minutes, more preferably in the range of 30 seconds to 2 minutes from the view point of not only preventing excess removal of amorphous silicon film except for undesirable thin film, but also easy control of etching.

After the amorphous silicon semiconductor layer is patterned like this, the substrate is set to a tray wherein a wire mask is arranged like the above-mentioned film formation apparatus and the back electrode is formed, for example, by sputtering metals such as Aℓ, Cr and Ag. Film formation may be carried out by other method such as vapour deposition method. Diameter of wires is selected in the same way as in the amorphous semiconductor layer patterning.

After the back electrode is formed, if any undesirable thin film is found in the obtained back electrode, it is removed by the undermentioned ways.

The undesirable thin film formed behind the wires can be removed by a wet etching method, dry etching methods such as plasma etching method, and a reverse sputtering method.

When the wet etching method is adopted, the undesirable thin film formed behind the wires can be romeved by soaking the whole substrate into mixture of phosphoric acid, acetic acid, nitric acid and demineralized water, for example, for $A\ell$ back electrode. And then the substrate is washed and dried. The ratio by volume of phosphoric acid, acetic acid, nitric acid and demineralized water in the mixture is, for example, 16:2:1:1 in that order. The ratio can be changeable in accordance with the total thickness of $A\ell$ film or amount of formed undesirable thin film and the thickness thereof. When the amount of undesirable film is a little and the thickness thereof is thin, it is preferable that mixture of which the ratio by volume of phosphoric acid, acetic acid, nitric acid and demineralized water is 16:2:1:5 in that order is used. Temperature of the mixture can be selected in the same way as in the amorphous semiconductor layer patterning. Etching period is preferably in the range of 10 seconds to 5 minutes, more preferably 30 seconds to 1 minute, from the view point of removing the undesirable film formed behind the wires without fail and preventing excess removal of $A\ell$ film except for the undesirable film. In addition to the above-mentioned mixture, diluted hydrochloric acid; KOH solution; mixture of ferric chloride, concentrated hydrochloric acid and demineralized water; or the like can be adopted as etchant.

When the back electrode is Cr or Ag, defect of patterning lines is removed in the same way as in $A\ell$ back electrode except that etchant is different from that of $A\ell$ back electrode.

Composition of etchant for Cr electrode can be perchloric acid: 20 ~ 30 mℓ , and demineralized water: 300 ~ 1000 mℓ per 100 grams of ammonium ceric nitrate. Preferable composition is, for example, 26 mℓ of perchloric acid and 400 mℓ of demineralized water per 100 grams of ammonium ceric nitrate.

Mixture of chromic acid anhydride of 30 ~ 50 grams, concentrated sulfuric acid of 10 ~ 30 mℓ and demineralized water of 1000 ~ 5000 mℓ; or ferric nitrate solution of 30 ~ 60 % by weight can be used as etchant for Ag electrode. Mixture of chromic acid anhydride of 40 grams, concentrated sulfuric aicd of 20 mℓ and demineralized water of 2000 mℓ, or ferric nitrate solution of 55 % by weight is enumerated as preferable example of etchant.

When double layer of back electrode, for example, Cr (20 ~ 100Å)/Aℓ (1000 ~ 10000Å), is formed in order to prevent metal component from diffusing into the amorphous semiconductor layer, it is enough for Aℓ layer to be applied to etching since thickness of the first layer formed on the semiconductor (in this case Cr layer) is thin and influence of undesirable film, even if formed, is neglected. It is enough for Aℓ layer to be applied to etching when the double layer back electrole is of Ag (20 ~ 100Å) /Aℓ (1000 ~ 10000Å).

Defect of patterning lines can be removed in a similar way for other metal electrode.

As mentioned above, a method of the present invention is characterized in that the removing step is adopted if necessary although the above description is made for solar cell wherein undesirable film is found in the patterning lines. And therefore, patterning can be carried out by combining one having a removing step and the other having no removing step.

Hereinafter is a description of examples of the fabrication method for semiconductor device of the present invention and the film formation apparatus for said method. The present invention, however, is not limited to the examples.

Example 1

SnO$_2$ transparent electrode of 6000Å thickness was formed on a blue plate glass of which thickness was 2 mm and size was 150 mm X 440 mm, and the transparent electrode was patterned as desired by laser beam. A substrate 1 whereon a pattern was formed like this was fixed to a CVD tray 2 shown in Fig. 1. The substrate 1 is positioned by four substrate positioning jigs 9 at four points. Total 17 fine piano wires 3 of grade B having 0.3 mm wire thickness (diameter) were adopted. Tension of each wire was adjusted by tension adjusting screw 8 before the substrate 1 was fixed in the tray 2. Fig. 2 shows the substrate 1 fixed to the tray 2.

After the tray 2 in which the substrate 1 was fixed was placed in a plasma CVD apparatus, 150Å thickness of p-type amorphous silicon carbide was formed under the condition that substrate temperature was 130°C and that pressure was 1.0 Torr, 6000Å thickness of i-type amorphous silicon was formed under the condition that substrate temperature was 180°C and that pressure was 0.5 Torr, and 300Å thickness of n-type microcrystalline silicon was formed under the condition that substrate temperature was 180°C and that pressure was 1.0 Torr. After that, CVD tray was taken out and the substrate was released from the tray. The masked parts by wires were examined. Although undesirable film is observed, there was no undesirable film which would be able to affect the efficiency of the device. Minimum patterning line width was measured for each patterning lines where transparent electrode was exposed by fine projector. The results are shown in Table 1.

Table 1

| Patterning line No. | 1 | 2 | 3 | 4 | 5 | 6 | 7 | 8 | 9 |
|---|---|---|---|---|---|---|---|---|---|
| Minimum patterning line width (μm) | 170 | 150 | 130 | 180 | 160 | 190 | 200 | 140 | 200 |

| Patterning line No. | 10 | 11 | 12 | 13 | 14 | 15 | 16 | 17 |
|---|---|---|---|---|---|---|---|---|
| Minimum patterning line width (μm) | 180 | 160 | 150 | 170 | 170 | 160 | 130 | 160 |

EP 0 373 221 A1

- 10 -

The distance between the edge of patterning line of transparent electrode and that of semiconductor layer which was near the transparent electrode was about 150 μm.

The obtained substrate having semiconductor layer patterned by that way was fixed to a sputtering tray having similar mechanism shown in Fig. 1 with the semiconductor layer being faced the wires. In this sputtering tray, 17 fine wires were shifted in right-angled direction to the wires shown in Fig. 1 by 0.25 mm. 0.2 mm diameter of wires were adopted. Tension of wires were adjusted by adjusting screws before the substrate was fixed to the sputtering tray.

After the tray in which the substrate was set was placed in a magnetron sputtering apparatus, 5000Å thickness of Aℓ film was formed under the condition that Ar pressure was adjusted at $6 \times 10^{-3}$ Torr and that temperature of the substrate was settled at 80°C. After that, the substrate was taken out and patterning line width of Aℓ back electrode was measured in the above-mentioned way. Minimum patterning line width for each patterning lines where Aℓ was masked so that the semiconductor layer was fully exposed are shown in Table 2.

Table 2

| Patterning line No. | 1 | 2 | 3 | 4 | 5 | 6 | 7 | 8 | 9 |
|---|---|---|---|---|---|---|---|---|---|
| Minimum patterning line width ($\mu$m) | 120 | 90 | 110 | 100 | 90 | 100 | 100 | 120 | 130 |

| Patterning line No. | 10 | 11 | 12 | 13 | 14 | 15 | 16 | 17 |
|---|---|---|---|---|---|---|---|---|
| Minimum patterning line width ($\mu$m) | 110 | 130 | 130 | 120 | 100 | 140 | 130 | 130 |

EP 0 373 221 A1

As shown in Table 2, the results are good since there is no incomplete patterned part.

The efficiency of the obtained solar cells was measured with AM-1.5 solar pulse-simulator. The results are shown in Table 3.

Table 3

|  | Isc (mA) | Voc (V) | FF (%) | Maximum power (Wp) |
|---|---|---|---|---|
| Example 1 | 410 | 16.1 | 63 | 4.16 |
| Comparative Example 1 | 400 | 16.0 | 60 | 3.84 |

Comparative Example 1

After a substrate of which transparent electrode was patterned in the same way as that of Example 1 was set to a similar CVD tray shown in Fig. 1 except that no wires were provided, a semiconductor layer was formed on the most part of trnasparent electrode under the same conditions as those of Example 1. The semiconductor layer was patterned by YAG laser. After Aℓ sputtering was carried out with no use of fine wires, and a back electrode was formed on the most part of the semiconductor under the same conditions as those of Example 1, Aℓ back electrode was patterned by chemical etching.

The efficiency of the obtained solar cell was measured in the same way as that of Example 1. The results are shown in Table 3.

Example 2

After $SnO_2$ transparent electrode of 6000Å thickness was formed by plasma CVD method on a blue plate glass of which thickness was 2.0 mm and size was 150 mm X 440 mm, the obtained transparent electrode was patterned by laser beam. The substrate having patterned transparent electrode was fixed to the CVD tray 2 of the plasma CVD apparatus. Total 17 piano wires of grade B having 0.3 mm wire thickness (diameter) were adopted. After CVD tray 2 in which the substrate was fixed was set to a plasma CVD apparatus, p-type amorphous silicon layer of 150Å thickness was formed under the condition that temperature of the substrate was 130°C and that pressure was 1.0 Torr, i-type amorphous silicon layer of 6000Å thickness was formed under the condition that temperature of the substrate was 180°C and that pressure was 0.5 Torr; and n-type microcrystalline silicon of 300Å thickness was formed under the condition that temperature of the substrate was 180°C and that pressure was 1.0 Torr. After that, CVD tray 2 was taken out and the substrate was released from the tray. When the masked parts were examined, it was observed that undesirable films were clearly formed. After the examination was finished, the substrate on which the amorphous semiconductor layer was formed was soaked into 10 % by weight KOH solution of 20°C for 30 seconds to etch the undesirable films. The masked parts were examined again, and no undesirable films were observed. Thickness of the semiconductor layer which were not masked by wires scarcely decreased by etching. The minimum patterning line width for each patterning lines was measured for the parts where the transparent electrode was fully exposed by fine projector. The mean value for 17 wires was 220 μm.

The distance between the edge of patterning line of transparent electrode and that of semiconductor layer which was near the transparent electrode was about 150 μm.

The obtained substrate having semiconductor layer patterned by that way was fixed to a sputtering tray having similar mechanism adopted by the sputtering tray for semiconductor layer with the semiconductor layer

EP 0 373 221 A1

- 14 -

being faced to the wires.  In this sputtering tray, 17 fine wires were shifted in right-angled direction to the wires of semiconductor layer patterning by 0.25 mm.  0.2 mm diameter of wires were adopted.

After the tray in which the substrate was set was placed in a magnetron sputtering apparatus, Cr film of 50Å thickness was formed under the condition that temperature of the substrate was 80°C with Ar pressure being adjusted at $1 \times 10^{-3}$ Torr, and Aℓ film of 5000Å was formed under the condition that temperature of the substrate was 80°C with Ar pressure being adjusted at $6 \times 10^{-3}$ Torr.  After that, the substrate was taken out and the masked parts of Cr/Aℓ back electrode were examined. It was observed that undesirable films were formed at some places in a degree that a short circuit was made. The substrate on which Cr/Aℓ back electrode was formed was soaked into mixture comprising phosphoric acid of 400 mℓ, acetic acid of 50 mℓ, nitric acid of 25 mℓ and demineralized water of 25 mℓ at 20°C for 30 seconds, and the undesirable film was etched.  The masked parts were examined again, however, no undesirable films and no short-circuited part were observed.  Patterning line width of Cr/Aℓ back electrode was measured in the above-mentioned way.  The mean value of the minimum patterning line width at the place where the semiconductor layer was fully exposed was 180 µm for 17 wires.  Since decrease of Aℓ film was 100 ~ 200 Å at the places which were not masked by wires, the efficiency of the semiconductor device would not be affected.

The efficiency of the obtained solar cell was measured with AM-1.5 solar pulse-simulator.  The results are shown in Table 4.

Table 4

|  | Isc (mA) | Voc (V) | FF (%) | Maximum power (Wp) |
|---|---|---|---|---|
| Example 2 | 405 | 16.2 | 64 | 4.21 |
| Comparative Example 2 | 402 | 16.1 | 60 | 3.88 |

Comparative Example 2

After a substrate of which transparent electrode was patterned in the same way as that of Example 2 was set to a similar CVD tray of Example 2 except that no wires were provided, a semiconductor layer was formed on the most part of transparent electrode under the same condition as those of Example 2. The semiconductor layer was patterned by YAG laser. After Aℓ sputtering was carried out with no use of fine wires, and back electrode was formed on the most part of the semiconductor under the same conditions as those of Example 2, Aℓ back electrode was patterned by chemical etching.

The efficiency of the obtained solar cell was measured by the same way as that of Exampel 2. The results are shown in Table 4.

From Tables 3 to 4, it is understandable that solar cells of the present invention have the same or more efficiency than those of conventional solar cells.

INDUSTRIAL APPLICABILITY

As is mentioned above, even if undesirable thin films are formed behind the wires, solar cells can be fully patterned in accordance with the fabrication method for semiconductor device and the film formation apparatus for said method. As a result, yield rate of solar cells is increased. Additional effects that severe adjustment of wires, complicated procedures such as application of resist, curing of the resist and removal of resist are not required.

CLAIMS

1. A fabrication method for semiconductor device wherein a patterned transparent electrode, an amorphous silicon semiconductor layer and a back electrode are formed in this order on a substrate characterized in that patterning for the amorphous semiconductor layer and/or the back electrode are/is formed by a step wherein wires are substantially and closely contacted with a surface whereon a film is formed, and by a step wherein undesirable film which is formed behind the wires during the above-mentioned step is removed, whenever necessary.

2. A fabrication method for semiconductor device according to Claim 1, wherein the diameter of the wire is in the range of 0.08 to 2.0 mm.

3. A fabrication method for semiconductor device according to claims 1 to 2, wherein a removing means for undesirable films formed behind the wires is etching.

4. A fabrication method for semiconductor device according to Claim 3, wherein the etching is wet etching.

5. A fabrication method for semiconductor device according to Claim 4, wherein etchant for amorphous silicon semiconductor layer is KOH solution or NaOH solution.

6. A fabrication method for semiconductor device according to claim 4, wherein the back electrode comprises Aℓ, and etchant is mixture of phosphoric acid, acetic acid, nitric acid and demineralized water; diluted hydrochloride acid; KOH solution; or mixture of ferric chloride; concentrated hydrochloric acid and demineralized water.

7. A fabrication method for semiconductor device according to Claim 4, wherein the back electrode comprises Cr, and etchant is mixture of ammonium ceric nitrate, perchloric acid and demineralized water.

8. A fabrication method for semiconductor device according to Claim 4, wherein the back electrode comprises Ag, and etchant is mixture of chromic acid anhydride, concentrated sulfuric acid and demineralized water; mixture of ferric nitrate solution, ammonia water, and hydrogen peroxide water; or diluted nitric acid.

9. A fabrication method for semiconductor device according to Claim 4, wherein the back electrode is Cr/Aℓ double layer type and etchant is of Claim 6.

10. A fabrication method for semiconductor device according to Claim 4, wherein the back electrode is Ag/Aℓ double layer type and etchant is of Claim 6.

11. A fabrication method for semiconductor device according to Claim 3, wherein the etching method is dry etching.

12. A fabrication method for semiconductor device according to Claim 11, wherein the dry etching is plasma etching.

13. A fabrication method for semiconductor device according to Claims 1 to 2, wherein the means adopted at removing step is reverse sputtering.

14. A film formation apparatus used at forming a semiconductor layer or a back electrode of a solar cell comprising a main body which contains a substrate, a means which fixes and positions the substrate, and a plurality of fine wires which are substantially and closely contacted with a film forming surface of the substrate.

15. An apparatus according to Claim 14, wherein a mechanism adjusting tension of the wires is provided.

16. An apparatus according to Claims 14 to 15, wherein the diameter of wire is in the range of 0.08 - 2.0 mm.

F I G . 1

FIG.2

# INTERNATIONAL SEARCH REPORT

International Application No PCT/JP 38/01147

**I. CLASSIFICATION OF SUBJECT MATTER** (if several classification symbols apply, indicate all) ⁶

According to International Patent Classification (IPC) or to both National Classification and IPC

Int. Cl⁴ H01L31/04

**II. FIELDS SEARCHED**

Minimum Documentation Searched ⁷

| Classification System | Classification Symbols |
|---|---|
| IPC | H01L31/04, H01L21/285, H01L21/308 |

Documentation Searched other than Minimum Documentation
to the Extent that such Documents are Included in the Fields Searched ⁸

Jitsuyo Shinan Koho                1978 - 1988
Kokai Jitsuyo Shinan Koho          1978 - 1988

**III. DOCUMENTS CONSIDERED TO BE RELEVANT** ⁹

| Category * | Citation of Document, ¹¹ with indication, where appropriate, of the relevant passages ¹² | Relevant to Claim No. ¹³ |
|---|---|---|
| Y | JP, A, 59-202671 (Matsushita Electric Ind. Co., Ltd.) 16 November 1984 (16. 11. 84) (Fig. 2(b), page 2, lower left column, line 17 to lower right column, line 1) (Family: none) | 1 - 2 |
| Y | JP, B2, 58-25738 (Westinghouse Electric Corp.) 30 May 1983 (30. 05. 83) (Page 2, left column, lines 16 to 24) & US, A, 3997932 & FR, A1, 2294113 & DE, A1, 2555726 | 1-2, 14-16 |
| Y | JP, A, 56-138929 (Canon Inc.) 29 October 1981 (29. 10. 81) (Page 2, upper left column, lines 6 to 7, Table 1) (Family: none) | 3 - 5 |
| Y | JP, A, 57-207342 (Fuji Electric Mfg. Co., Ltd.) 20 December 1982 (20. 12. 82) (Page 1, left column, lines 15 to 17) (Family: none) | 3-4, 6, 9-10 |

\* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| February 3, 1989 (03. 02. 89) | February 20, 1989 (20. 02. 89) |

| International Searching Authority | Signature of Authorized Officer |
|---|---|
| Japanese Patent Office | |

Form PCT ISA 210 (second sheet) (January 1985)

| FURTHER INFORMATION CONTINUED FROM THE SECOND SHEET | |
|---|---|
| Y | JP, A, 60-74533 (Hitachi, Ltd.)<br>26 April 1985 (26. 04. 85)<br>(Page 2, left column, lines 15 to 16)<br>(Family: none) | 3-4, 6, 9-10 |
| Y | JP, A, 47-5555 (International Business Machines Corp.)<br>23 March 1972 (23. 03. 72)<br>(Page 3, lower left column, lines 5 to 14)<br>(Family: none) | 3-4, 7 |

## V. ☐ OBSERVATIONS WHERE CERTAIN CLAIMS WERE FOUND UNSEARCHABLE [10]

This international search report has not been established in respect of certain claims under Article 17(2) (a) for the following reasons:

1. ☐ Claim numbers_____ because they relate to subject matter [12] not required to be searched by this Authority, namely:

2. ☐ Claim numbers_____ because they relate to parts of the international application that do not comply with the prescribed requirements to such an extent that no meaningful international search can be carried out [13], specifically

## VI. ☐ OBSERVATIONS WHERE UNITY OF INVENTION IS LACKING [11]

This International Searching Authority found multiple inventions in this international application as follows:

1. ☐ As all required additional search fees were timely paid by the applicant, this international search report covers all searchable claims of the international application.

2. ☐ As only some of the required additional search fees were timely paid by the applicant, this international search report covers only those claims of the international application for which fees were paid, specifically claims:

3. ☐ No required additional search fees were timely paid by the applicant. Consequently, this international search report is restricted to the invention first mentioned in the claims; it is covered by claim numbers:

4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees

Form PCT/ISA/210 (supplemental sheet (2)) (October 1981)

FURTHER INFORMATION CONTINUED FROM THE SECOND SHEET

| | | |
|---|---|---|
| Y | Naraoka Kiyotake [Electronics no Seimitsu Bisai Kako]<br>20 August 1983 (20. 08. 83)<br>Sogo Denshi Shuppan-sha (Tokyo)<br>(Page 88, Table 3.5) (Family: none) | 5 - 11 |
| Y | JP, A, 57-208182 (Semiconductor Energy Kenkyusho Kabushiki Kaisha)<br>21 December 1982 (21. 12. 82)<br>(Page 2, lower left column, lines 16 to 20)<br>(Family: none) | 9 |

V.☐ OBSERVATIONS WHERE CERTAIN CLAIMS WERE FOUND UNSEARCHABLE ¹

This international search report has not been established in respect of certain claims under Article 17(2) (a) for the following reasons:

1.☐ Claim numbers , because they relate to subject matter not required to be searched by this Authority, namely:

2.☐ Claim numbers ......, because they relate to parts of the international application that do not comply with the prescribed requirements to such an extent that no meaningful international search can be carried out, specifically.

3.☐ Claim numbers ...... .. ..., because they are dependent claims and are not drafted in accordance with the second and third sentences of PCT Rule 6.4(a).

VI.☐ OBSERVATIONS WHERE UNITY OF INVENTION IS LACKING ²

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)

| FURTHER INFORMATION CONTINUED FROM THE SECOND SHEET | | |
|---|---|---|
| Y | JP, A, 58-35989 (Sanyo Electric Co., Ltd.) 2 March 1983 (02. 03. 83) (Page 2, lower left column, line 2 to lower right column, line 1) (Family: none) | 10 |

---

**V. ☐ OBSERVATIONS WHERE CERTAIN CLAIMS WERE FOUND UNSEARCHABLE** [1]

This international search report has not been established in respect of certain claims under Article 17(2) (a) for the following reasons:

1. ☐ Claim numbers ..........., because they relate to subject matter not required to be searched by this Authority, namely:

2. ☐ Claim numbers ..........., because they relate to parts of the international application that do not comply with the prescribed requirements to such an extent that no meaningful international search can be carried out, specifically:

3. ☐ Claim numbers ..........., because they are dependent claims and are not drafted in accordance with the second and third sentences of PCT Rule 6.4(a).

---

**VI. ☐ OBSERVATIONS WHERE UNITY OF INVENTION IS LACKING** [2]

This International Searching Authority found multiple inventions in this international application as follows:

1. ☐ As all required additional search fees were timely paid by the applicant, this international search report covers all searchable claims of the international application.

2. ☐ As only some of the required additional search fees were timely paid by the applicant, this international search report covers only those claims of the international application for which fees were paid, specifically claims:

3. ☐ No required additional search fees were timely paid by the applicant. Consequently, this international search report is restricted to the invention first mentioned in the claims; it is covered by claim numbers:

4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)